# EUROPEAN PATENT APPLICATION

(11) **EP 4 575 804 A1**
(43) Date of publication of application: **25.06.2025**
(21) Application number: 24217433.2
(22) Date of filing: 04.12.2024
(51) Int. Cl.: G06F 11/3668, B60W 60/00

(54) **SYSTEM AND METHOD FOR GENERATING DATA-BASED AUTONOMOUS DRIVING TEST SCENARIOS FOR TESTING AND EVALUATION OF AUTONOMOUS DRIVING SYSTEMS**

(30) Priority: 18.12.2023 KR 20230184809
(71) Applicant: Korea Electronics Technology Institute, Bundang-gu, Seongnam-si Gyeonggi-do 13509 (KR)
(72) Inventor: SUNG, Gi Ho, 13604 Seongnam-si, Gyeonggi-do (KR); MIN, Kyoung Won, 13581 Seongnam-si, Gyeonggi-do (KR); PARK, Jin Man, 12736 Gwangju-si, Gyeonggi-do (KR); SON, Haeng Seon, 13588 Seongnam-si, Gyeonggi-do (KR); LEE, Seon Young, 04717 Seoul (KR); SHIM, Young Bo, 13604 Seongnam-si, Gyeonggi-do (KR)
(74) Representative: Isarpatent

(57) **Abstract**

There are provided a system and a method for generating data-based autonomous driving test scenarios for testing and evaluation of autonomous driving system. An autonomous driving test scenario generation method according to an embodiment generates tracked objects by using tracked object data that an autonomous driving vehicle collects while traveling, determines some non-tracked objects among the tracked objects and reflects a non-tracking factor on non-tracked object data, and generates an autonomous driving test scenario by using elements within an operational design domain of an autonomous test scenario and the non-tracked object data reflecting the non-tracking factor. Accordingly, scenarios for testing not only determination, control functions but also a recognition function are generated based on data acquired by autonomous driving, so that more inclusive, detailed testing and evaluation can be provided for autonomous driving systems performing dynamic driving tasks.

## Description

### CROSS-REFERENCE TO RELATED APPLICATION(S) AND CLAIM OF PRIORITY

This application is based on and claims priority under 35 U.S.C. § 119 to Korean Patent Application No. 10-2023-0184809, filed on December 18, 2023, in the Korean Intellectual Property Office, the disclosure of which is herein incorporated by reference in its entirety.

### BACKGROUND

### FIELD

The disclosure relates to autonomous driving test scenario generation, and more particularly, to a system and a method for generating scenarios for testing and evaluation of autonomous driving by processing data collected from autonomous driving vehicles.

### DESCRIPTION OF RELATED ART

To introduce vehicles equipped with autonomous driving systems to the market, rational verification and evaluation of autonomous driving systems are required. A scenario-based testing method may be used to test autonomous driving systems.

The scenario-based testing method generates and tests scenarios in various situations to identify whether an autonomous driving system, which performs a dynamic driving task including recognition, determination, control functions to be able to drive instead of a driver, can normally operate within an operational design domain (a domain related to roads, weather, traffic).

However, such a related-art scenario-based testing method is only focused on testing of determination and control of autonomous driving systems, and scenarios are not generated in case an error in recognition occurs.

However, accurate recognition should be guaranteed for correct determination and control of autonomous driving systems, and hence, there is a need for a solution to complement a related-art scenario-based testing method. In particular, a recognition test based on data according to autonomous driving situations rather than a recognition test based on normal data is required.

### SUMMARY

The disclosure has been developed in order to solve the above-described problems, and an object of the disclosure is to provide a system and a method for generating scenarios for evaluating an autonomous driving system which performs a dynamic driving task including recognition, determination, control functions based on data acquired by autonomous driving.

To achieve the above-described object, an autonomous driving test scenario generation method according to an embodiment may include: a step of generating tracked objects by using tracked object data that an autonomous driving vehicle collects while traveling; a step of determining a non-tracked object and supplementing a non-tracking section; a step of reflecting a non-tracking factor on non-tracked object data; a step of identifying elements within an operational design domain of an autonomous driving test scenario; and a step of generating an autonomous driving test scenario by using the identified elements and the non-tracked object data reflecting the non-tracking factor.

The identified elements may include dynamic elements, static elements, and environmental elements.

the step of generating the autonomous driving test scenario may include using the non-tracked object data reflecting the non-tracking factor for the non-tracked object among the identified dynamic elements when generating the autonomous driving test scenario by using the identified elements.

The step of supplementing may include determining, as a non-tracked object, a tracked object for which an interval between a tracking end time and a next tracking start time is less than or equal to a predetermined time, and a distance between a tracking end point and a next tracking start point is less than or equal to a predetermined distance.

The step of reflecting may include: a step of analyzing a non-tracking factor of the non-tracked object; and a step of reflecting the analyzed non-tracking factor on non-tracked object data.

The non-tracking factor may include a color and a reflectivity of the non-tracked object.

According to an embodiment, the autonomous driving test scenario generation method may further include a step of determining a mis-tracked object and filtering out the mis-tracked object.

The step of filtering may include determining the mis-tracked object based on a motion state of a tracked object.

According to an embodiment, the autonomous driving test scenario generation method may further include a step of organizing tracked object data regarding tracked objects which are left after filtering and supplementing.

According to another aspect of the disclosure, there is provide an autonomous driving test scenario generation system including: an object generation unit configured to generate tracked objects by using tracked object data that an autonomous driving vehicle collects while traveling; a supplementation unit configured to determine a non-tracked object and to supplement a non-tracking section; a reflection unit configured to reflect a non-tracking factor on non-tracked object data; an identification unit configured to identify elements within an operational design domain of an autonomous driving test scenario; and a scenario generation unit configured to generate an autonomous driving test scenario by using the identified elements and the non-tracked object data reflecting the non-tracking factor.

According to still another aspect of the disclosure, there is provided an autonomous driving test scenario generation method including: a step of storing tracked object data that an autonomous driving vehicle collects while traveling; a step of generating tracked objects by using the stored tracked object data; a step of determining some non-tracked objects among the tracked objects and reflecting a non-tracking factor on non-tracked object data; and a step of generating an autonomous driving test scenario by using elements within an operational design domain of an autonomous test scenario and the non-tracked object data reflecting the non-tracking factor.

According to yet another aspect of the disclosure, there is provided an autonomous driving test scenario generation system including: a DB configured to store tracked object data that an autonomous driving vehicle collects while traveling; an object generation unit configured to generate tracked objects by using the stored tracked object data; a reflection unit configured to determine some non-tracked objects among the tracked objects and to reflect a non-tracking factor on non-tracked object data; and a scenario generation unit configured to generate an autonomous driving test scenario by using elements within an operational design domain of an autonomous test scenario and the non-tracked object data reflecting the non-tracking factor.

As described above, according to various embodiments of the disclosure, scenarios for testing not only determination, control functions but also a recognition function are generated based on data acquired by autonomous driving, so that more inclusive, detailed testing and evaluation can be provided for autonomous driving systems performing dynamic driving tasks.

Other aspects, advantages, and salient features of the invention will become apparent to those skilled in the art from the following detailed description, which, taken in conjunction with the annexed drawings, discloses exemplary embodiments of the invention.

Before undertaking the DETAILED DESCRIPTION OF THE INVENTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like. Definitions for certain words and phrases are provided throughout this patent document, those of ordinary skill in the art should understand that in many, if not most instances, such definitions apply to prior, as well as future uses of such defined words and phrases.

### BRIEF DESCRIPTION OF THE DRAWINGS

For a more complete understanding of the present disclosure and its advantages, reference is now made to the following description taken in conjunction with the accompanying drawings, in which like reference numerals represent like parts:
FIG. 1 is a view illustrating an autonomous driving test scenario generation system according to an embodiment of the disclosure;
FIG. 2 is a view illustrating a detailed configuration of a tracked object processing unit;
FIG. 3 is a view illustrating a detailed configuration of a non-tracking factor reflection unit;
FIG. 4 is a view illustrating a detailed configuration of a scenario area identification unit;
FIG. 5 is a view illustrating an autonomous driving test scenario generation method according to an embodiment of the disclosure;
FIG. 6 is a view illustrating an autonomous driving test scenario generation method according to an embodiment of the disclosure.

### DETAILED DESCRIPTION

Hereinafter, the disclosure will be described in more detail with reference to the accompanying drawings.

Embodiments of the disclosure provide a system and a method for generating data-based autonomous test scenarios for testing and evaluation of autonomous driving systems.

The disclosure relates to a technology for generating scenarios for testing not only determination, control functions but also a recognition function based on real data acquired by autonomous driving, and providing more inclusive, detailed testing and evaluation for autonomous driving systems which perform dynamic driving tasks.

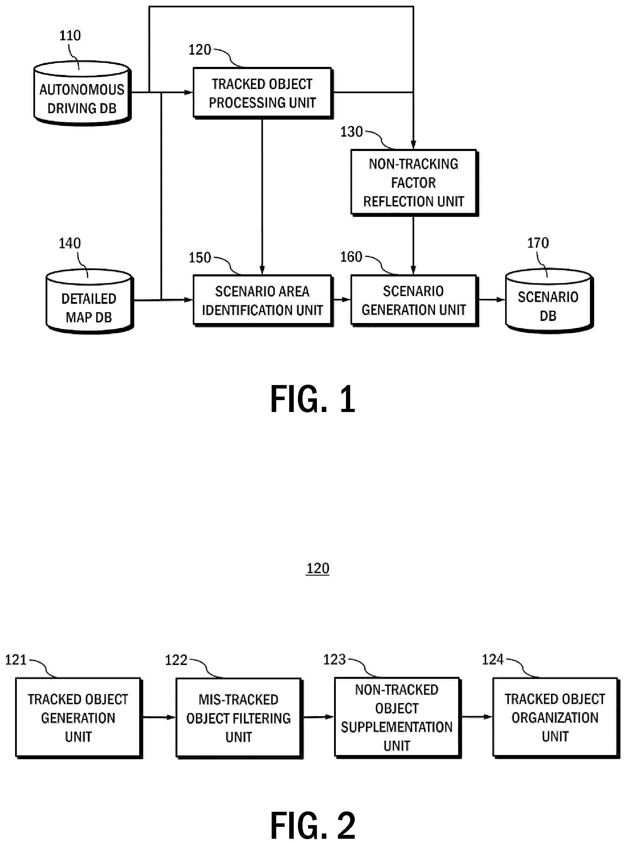

FIG. 1 is a view illustrating a configuration of an autonomous driving test scenario generation system according to an embodiment of the disclosure. As shown in FIG. 1, the autonomous driving test scenario generation system according to an embodiment may include an autonomous driving database (DB) 110, a tracked object processing unit 120, a non-tracking factor reflection unit 130, a detailed map DB 140, a scenario area identification unit 150, a scenario generation unit 160, and a scenario DB 170.

The autonomous driving DB 110 is a database in which sensor data that autonomous driving vehicles collect while really traveling, tracked object data, internal/external state data, weather data, etc. are stored.

The tracked object processing unit 120 generates tracked objects by using tracked object data stored in the autonomous driving DB 110, and performs a necessary subsequent process for the tracked objects. A detailed configuration of the tracked object processing unit 120 is illustrated in FIG. 2.

As shown in FIG. 2, the tracked object processing unit 120 may include a tracked object generation unit 121, a mis-tracked object filtering unit 122, a non-tracked object supplementation unit 123, and a tracked object organization unit 124.

The tracked object generation unit 121 generates tracked objects by using tracked object data stored in the autonomous driving DB 110. Attributes of the tracked object data may include classification data, size data, position data of objects, and may not include data regarding specific shapes, colors, materials.

The mis-tracked object filtering unit 122 determines a mis-tracked object among the objects generated by the tracked object generation unit 121, and filters out (removes) the mis-tracked object. Mis-tracked object determination may be performed based on a motion state of a tracked object.

Specifically, the mis-tracked object filtering unit 122 determines a state of an irrational individual tracked object and a state between irrational tracked objects, and removes a tracked object that is determined as being incorrectly tracked. The state of the irrational individual tracked object may include a short maximum tracking time, a speed change that is difficult to have really. The state between irrational tracked objects may include continuous collision for a predetermined time, collision with various tracked objects.

The non-tracked object supplementation unit 123 determines some non-tracked objects among the objects that are left after filtering by the mis-tracked object filtering unit 122, and supplements a non-tracking section. Some non-tracked objects are objects that switches from a tracked state to a non-tracked state and then switches from the non-tracked state to a tracked state (tracked state-non-tracked state-tracked state), for example, objects for which an interval between a tracking end time and a next tracking start time is less than or equal to a predetermined time, and a distance between a tracking end point and a next tracking start point is less than or equal to a predetermined distance.

The non-tracked object supplementation unit 123 generates tracked object data regarding a continuous section by supplementing/interpolating a non-tracking section for a non-tracked object.

The tracked object organization unit 124 organizes the tracked object data regarding tracked objects that are left after filtering by the mis-tracked object filtering unit 122 and supplementing by the non-tracked object supplementation unit 123.

Specifically, when the attribute of the tracked object data should have one value like a size, the tracked object organization unit 124 may select one value through a statical method, such as a median value, an average value, and may organize the tracked object data.

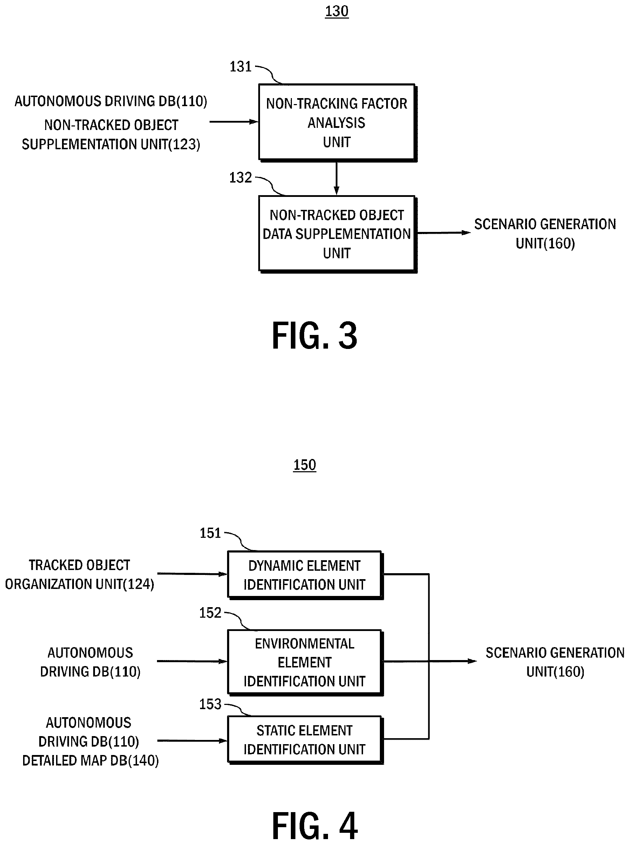

Referring back to FIG. 1, the non-tracking factor reflection unit 130 reflects a non-tracking factor on non-tracked object data, and transmits the data to the scenario generation unit 60. A detailed configuration of the non-tracking factor reflection unit 130 is illustrated in FIG. 3.

The non-tracking factor reflection unit 130 may include a non-tracking factor analysis unit 131 and a non-tracked object data supplementation unit 132.

The non-tracking factor analysis unit 131 analyzes a non-tracking factor of a non-tracked object that is determined by the non-tracked object supplementation unit 123. To achieve this, the non-tracking factor analysis unit 131 acquires sensor data obtained at a non-tracking time of the non-tracked object, and data of an internal state of an autonomous driving vehicle from the autonomous driving DB 110, and analyzes the data.

Specifically, the non-tracking factor analysis unit 131 determines which of a performance limit of a sensor (a maximum recognition distance, a recognition blind point, etc.), a characteristic of an object (for example, a color, a reflexibility of an object), a factor caused by other objects (occlusion) the non-tracking factor corresponds to.

The non-tracked object data supplementation unit 132 reflects the analyzed non-tracking factor on non-tracked object data. Specifically, when the non-tracking factor analyzed by the non-tracking factor analysis unit 131 is a characteristic of an object (for example, a color, a reflexibility of an object), the non-tracked object data supplementation unit 132 reflects the non-tracking factor on the non-tracked object by adding the color and the reflexibility of the object to tracked object data of the non-tracked object.

Referring back to FIG. 1, the detailed map DB 140 is a database in which detailed map data representing a road in the unit of a lane used by autonomous driving vehicles is stored.

The scenario area identification unit 150 identifies elements within an operational design domain of an autonomous driving test scenario. The operational design domain refers to an operational design domain according to ISO 34503:2023 standards.

A detailed configuration of the scenario area identification unit 150 is illustrated in FIG. 4. As shown in FIG. 4, the scenario area identification unit 150 may include a dynamic element identification unit 151, an environmental element identification unit 152, and a static element identification unit 153.

The dynamic element identification unit 151 identifies detailed items of dynamic elements in the operational design domain from the tracked object data which is organized by the tracked object organization unit 124.

The environmental element identification unit 152 identifies detailed items of environmental conditions in the operational design domain from weather data of the autonomous driving DB 110.

The static element identification unit 153 identifies detailed items of a static area (scenery) of the operational design domain from external state data of the autonomous driving DB 110 and detailed map data of the detailed map DB 140.

Referring back to FIG. 1, the scenario generation unit 160 generates autonomous driving test scenario by using dynamic elements, environmental elements, and static element which are identified by the scenario area identification unit 150. However, regarding a non-tracked object among dynamic elements, the scenario generation unit 160 uses non-tracked object data reflecting a non-tracking factor by the non-tracked object data supplementation unit 132 when generating a scenario.

The autonomous driving test scenario generated by the scenario generation unit 160 is stored in the scenario DB 170 and is used for testing and evaluating overall dynamic driving tasks including recognition, determination, control functions of autonomous driving systems.

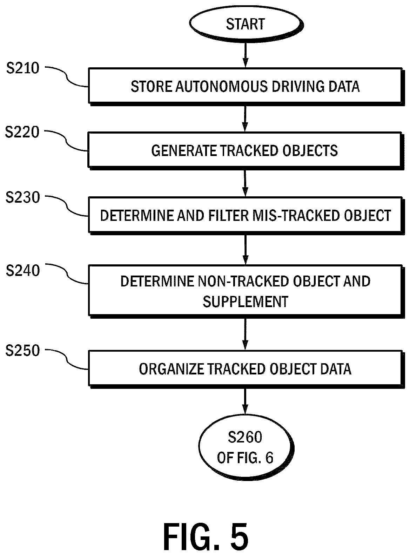

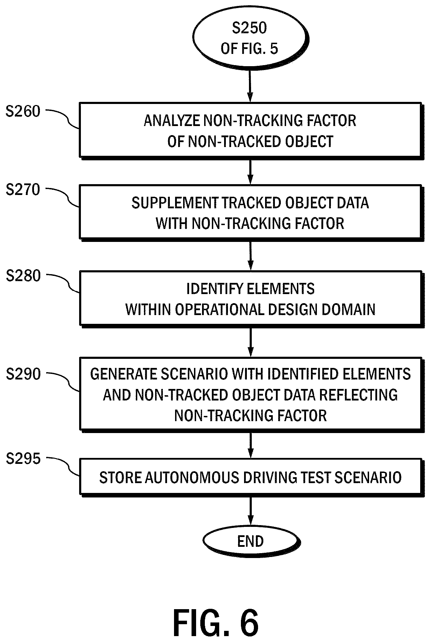

FIG. 5 is a view illustrating an autonomous driving test scenario generation method according to another embodiment of the disclosure, and FIG. 6 is a view illustrating an autonomous driving test scenario generation method according to another embodiment of the disclosure.

As shown in FIG. 5, in order to generate an autonomous driving test scenario, sensor data that autonomous driving vehicles collect while really traveling, tracked object data, internal/external state data, weather data are stored in the autonomous driving DB 110 (S210).

Then, the tracked object generation unit 121 of the tracked object processing unit 120 generates tracked objects by using tracked object data stored at step S210 (S220), and the mis-tracked object filtering unit 122 determines a mis-tracked object among the objects generated at step S220 and filters out the mis-tracked object (S230).

The non-tracked object supplementation unit 123 determines some non-tracked object among the objects that are left after filtering at step S230, and supplements a non-tracking section (S240). The tracked object organization unit 124 organizes tracked object data regarding tracked objects that are left after filtering at step S230 and supplementing at step S240 (S250).

Meanwhile, as shown in FIG. 6, the non-tracking factor analysis unit 131 of the non-tracking factor reflection unit 130 analyzes a non-tracking factor of the non-tracked object determined at step S240 (S260), and the non-tracked object data supplementation unit 132 supplements object data of the non-tracked object with the non-tracking factor (S270).

The scenario area identification unit 150 identifies dynamic elements, environmental elements, and static elements within an operational design domain of an autonomous test scenario (S280).

The scenario generation unit 160 generates an autonomous driving test scenario by using the dynamic elements, the environmental elements, and the static elements which are identified at step S280 (S290). At this step, regarding the non-tracked object among the dynamic elements, the non-tracked object data reflecting the non-tracking factor at step S270 is used.

The autonomous driving test scenario generated at step S290 is stored in the scenario DB 170.

Up to now, a data-based autonomous driving test scenario generation system and method for testing and evaluation of autonomous driving systems have been described.

In the above-described embodiments, scenarios for testing not only determination, control functions but also a recognition function are generated based on data acquired by autonomous driving, so that more inclusive, detailed testing and evaluation can be provided for autonomous driving systems performing dynamic driving tasks.

The technical concept of the disclosure may be applied to a computer-readable recording medium which records a computer program for performing the functions of the apparatus and the method according to the present embodiments. In addition, the technical idea according to various embodiments of the disclosure may be implemented in the form of a computer readable code recorded on the computer-readable recording medium. The computer-readable recording medium may be any data storage device that can be read by a computer and can store data. For example, the computer-readable recording medium may be a read only memory (ROM), a random access memory (RAM), a CD-ROM, a magnetic tape, a floppy disk, an optical disk, a hard disk drive, or the like. A computer readable code or program that is stored in the computer readable recording medium may be transmitted via a network connected between computers.

In addition, while preferred embodiments of the present disclosure have been illustrated and described, the present disclosure is not limited to the above-described specific embodiments. Various changes can be made by a person skilled in the at without departing from the scope of the present disclosure claimed in claims, and also, changed embodiments should not be understood as being separate from the technical idea or prospect of the present disclosure.

## Claims

1. An autonomous driving test scenario generation method comprising:
a step of generating tracked objects by using tracked object data that an autonomous driving vehicle collects while traveling;
a step of determining a non-tracked object and supplementing a non-tracking section;
a step of reflecting a non-tracking factor on non-tracked object data;
a step of identifying elements within an operational design domain of an autonomous driving test scenario; and
a step of generating an autonomous driving test scenario by using the identified elements and the non-tracked object data reflecting the non-tracking factor.

2. The autonomous driving test scenario generation method of claim 1, wherein the identified elements comprise dynamic elements, static elements, and environmental elements.

3. The autonomous driving test scenario generation method of claim 2, wherein the step of generating the autonomous driving test scenario comprises using the non-tracked object data reflecting the non-tracking factor for the non-tracked object among the identified dynamic elements when generating the autonomous driving test scenario by using the identified elements.

4. The autonomous driving test scenario generation method of claim 1, wherein the step of supplementing comprises determining, as a non-tracked object, a tracked object for which an interval between a tracking end time and a next tracking start time is less than or equal to a predetermined time, and a distance between a tracking end point and a next tracking start point is less than or equal to a predetermined distance.

5. The autonomous driving test scenario generation method of claim 4, wherein the step of reflecting comprises:
a step of analyzing a non-tracking factor of the non-tracked object; and
a step of reflecting the analyzed non-tracking factor on non-tracked object data.

6. The autonomous driving test scenario generation method of claim 5, wherein the non-tracking factor comprises a color and a reflectivity of the non-tracked object.

7. The autonomous driving test scenario generation method of claim 1, further comprising a step of determining a mis-tracked object and filtering out the mis-tracked object.

8. The autonomous driving test scenario generation method of claim 7, wherein the step of filtering comprises determining the mis-tracked object based on a motion state of a tracked object.

9. The autonomous driving test scenario generation method of claim 7, further comprising a step of organizing tracked object data regarding tracked objects which are left after filtering and supplementing.

10. An autonomous driving test scenario generation system comprising:
an object generation unit configured to generate tracked objects by using tracked object data that an autonomous driving vehicle collects while traveling;
a supplementation unit configured to determine a non-tracked object and to supplement a non-tracking section;
a reflection unit configured to reflect a non-tracking factor on non-tracked object data;
an identification unit configured to identify elements within an operational design domain of an autonomous driving test scenario; and
a scenario generation unit configured to generate an autonomous driving test scenario by using the identified elements and the non-tracked object data reflecting the non-tracking factor.

11. An autonomous driving test scenario generation method comprising:
a step of storing tracked object data that an autonomous driving vehicle collects while traveling;
a step of generating tracked objects by using the stored tracked object data;
a step of determining some non-tracked objects among the tracked objects and reflecting a non-tracking factor on non-tracked object data; and
a step of generating an autonomous driving test scenario by using elements within an operational design domain of an autonomous test scenario and the non-tracked object data reflecting the non-tracking factor.
